# EUROPEAN PATENT APPLICATION

(11) **EP 0 859 407 A2**
(43) Date of publication of application: **19.08.1998**
(21) Application number: 98200432.7
(22) Date of filing: 11.02.1998
(51) Int. Cl.: H01L 21/768, H01L 21/3213

(54) **Method of fabrication of a copper containing structure in a semiconductor device**

(30) Priority: 13.02.1997 US 37996 P
(71) Applicant: TEXAS INSTRUMENTS INCORPORATED, Dallas, TX 75265 (US)
(72) Inventor: Sudipto, Roy R., 10-04 Spring Grove, Singapore 249565 (SG); Mukherjee-Roy, Miotreyee, 526, Dallas, Texas, 75240 (US)
(74) Representative: Holt, Michael

(57) **Abstract**

An embodiment of the instant invention is a method of forming a conductive structure comprised of copper over a semiconductor substrate, the method comprising the steps of: depositing a copper-containing material (metal materials 24, 28, and 30) over the substrate (substrate 10); selectively oxidizing portions of the copper-containing material (layer 30 of FIGUREs 1b and 2a); and removing the oxidized portions of the copper-containing material. Preferably, the copper-containing material is comprised of substantially pure copper or aluminum doped with copper (preferably the copper doped aluminum contains at least 0.5% by weight of copper-more preferably between 0.5 and 4% by weight of copper). A mask (mask 32 of FIGUREs 1b and 2a) may be formed over a portion of the copper-containing material so as to retard oxidation of the copper-containing material under the mask. Preferably, the step of removing the oxidized portions of the copper containing material is performed by chemical mechanical polishing of the oxidized portions, etching the oxidized portions, or a combination of the two processes.

## Description

This invention relates generally to semiconductor device fabrication and more specifically, but not exclusively, to the formation and removal of portions of a structure which includes copper.

Future generations of semiconductor devices are likely to be smaller in size and require less power. Because of this, upper level metalizations must have lower sheet resistance and have better lectromigration properties. Copper incorporation into aluminum structures has been offered as a solution to these problems along with forming contact/vias/interconnects and associated metal lines purely from copper. However, copper structures and copper doped aluminum structures which have higher contents of copper are difficult to etch. Because of this problem, some semiconductor manufactures are considering using a damascene process whereby the contact/interconnect/via and associated overlying metal structure are cut out of the inverlevel dielectric layer prior to deposition of the metalization material (such as copper doped aluminum of substantially pure copper) so as to form a pattern in which the metalization material will fill. However, some form of removal/planarization process (such as chemical mechanical polishing, CMP) must be subsequently performed so as to remove any excess materials which overlie the interlevel dielectric material.

Most removal/planarirzation process do not work well with copper films or copper doped aluminum films where the copper is at least 1 to 2% by weight. More specifically, films containing large amounts of copper have a tendency to smear during CMP processes and endpoint detection. Furthermore, since it is difficult to determine when to stop the CMP process, extra material is typically removed from the contact/via/interconnect region (commonly referred to as "dishing"), which is undesirable. Additionally, typical CMP processes (as they relate to the removal of copper films or aluminum films which are heavily doped with copper) have other problems, such as: copper peeling, peeling of the underlying barrier layer, erosion of the copper structure, and corrosion of the copper structure.

An embodiment of the instant invention is a method of forming a conductive structure comprised of copper over a semiconductor substrate, the method comprising the steps of: depositing a copper-containing material over the substrate; selectively oxidizing portions of the copper-containing material; and removing the oxidized portions of the copper-containing material. Preferably, the copper-containing material is comprised of substantially pure copper or aluminum doped with copper (preferably the copper doped aluminum contains at least 0.5% by weight of copper - more preferably between 0.5 and 4% b weight of copper). A mask may be formed over a portion of the copper-containing material so as to retard oxidation of the copper-containing material under the mask. Preferably, the step of removing the oxidized portions of the copper containing material is performed by chemical mechanical polishing of the oxidized portions, etching the oxidized portions, or a combination of the two processes.

Another embodiment of the instant invention is a method of forming an interconnect/contact/via over a semiconductor substrate, the method comprising the steps of: providing a dielectric layer over the substrate, the dielectric layer having an upper surface, and an opening extending from the upper surface to the lower surface; depositing a copper-containing material so as to substantially fill the opening in the dielectric layer, the copper-containing material is also situated on the upper surface of the dielectric layer; oxidizing portions of the copper-containing material, and removing the oxidized portions of the copper-containing material is comprised of substantially pure copper or aluminum doped with copper (preferably aluminum doped with at least 0.5% copper by weight). In both embodiments of the instant invention, substantially all of the copper-containing material overlying the dielectric layer is, preferably, oxidized while the copper-containing material which substantially fills the opening in the dielectric layer remains substantially unoxidized. Preferably, the step of removing the oxidized portions of the copper-containing material is comprised of performing chemical mechanical polishing, performing a blanket etch process, or a combination of both. In a variation of this embodiment of this invention, a mask which does not readily oxidize and which does not readily allow oxygen to diffuse through it is formed over the portion of the copper-containing material which fills the opening in the dielectric layer.

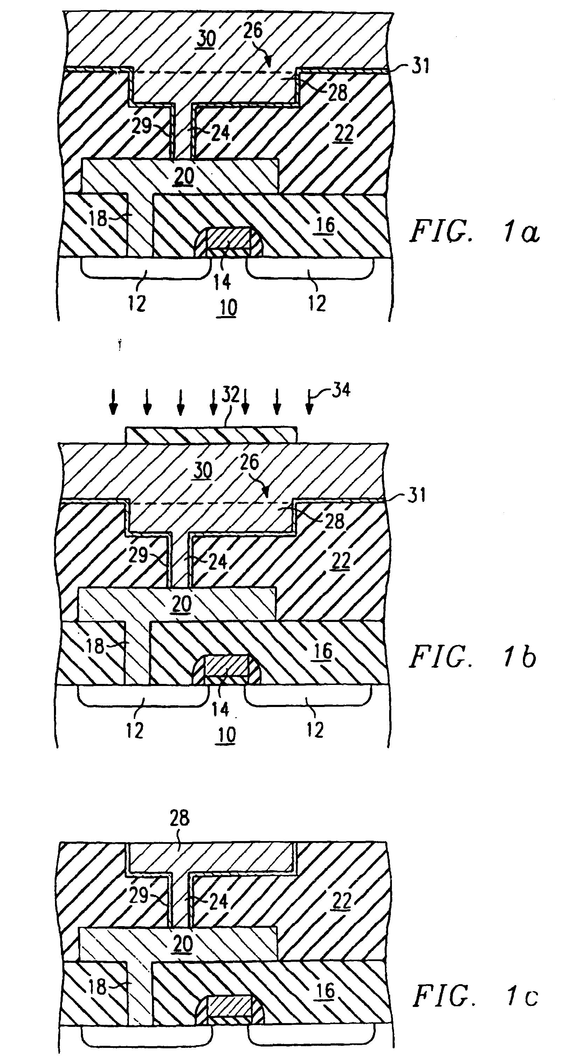

The present invention will now be further described by way of example, with reference to the accompanying drawings in which:
FIGUREs 1a-1c are cross-sectional views of a device fabricated using the method of one embodiment of the instant invention.
FIGUREs 2a-2b are cross-sectional views of a device fabricated using another embodiment of the instant invention.
Referring to the embodiment of FIGUREs 1a-1c, after several standard processing steps gate structure 14 (comprised of a conductive gate, gate insulator and sidewall insulators) is formed overlying substrate 10. Source/drain regions 12 are formed in substrate 10. This embodiment of the instant invention will be described with regards to the novel formation of interconnect 24 (which may also be a via, a trench, or a contact) and conductive line 28. However, embodiments of the instant invention could be used to form contact 18 and conductive line 20. In fact, they can be used to form both of these structures. If it is used to form contact 18 and conductor 20, care must be taken such that the copper will not leach into substrate 10 or insulator 16 so as to degrade device performance. If the novel method of embodiments in accordance with the instant invention is not utilized to form features 18 and 20, they may be comprised of polysilicon, tungsten, titanium, TiN, or any other conventionally used conductive or semiconductive material.

After structure 18 and 20 are formed, an interlevel dielectric 22 is formed. Preferably, dielectric layer 22 is comprised of BPSG, PSG, any type of spin-on glass, an oxide, TEOS, a low-k dielectric material (such as an aerogel, a zerogel, or a polymer with a low dielectric constant), or any other commonly used interlevel dielectric material. Using a damascene type process (as is illustrated in FIGUREs la-lc), an opening is formed in dielectric 22 for the interconnect and another opening is made in dielectric 22 for the conductor. These openings are preferably formed using standard techniques for a typical damascene process. After these openings are formed a liner/barrier layer 29 (on sides of openings and on bottom of conductor opening) and 31 (on uppermost surface of dielectric 22) is formed (and possibly etched away in certain places - or only formed in certain places). Preferably, liner 29 and 31 are comprised of tatanium, TiN, tantalum, tantalum nitride, or any combination thereof.

Next, a copper-containing material is deposited to form contact/via/interconnect 24 and conductive line 26 along with overfill 30. Preferably, the copper-containing material is comprised of substantially pure copper or copper doped aluminum (preferably on the order of 1 to 5% copper by weight-more preferably around 2 to 4% copper by weight). In order to more easily remove overfill 30, an embodiment of the instant invention involves oxidizing a portion of overfill 30. All of overfill 30 does not have to be oxidized. It is preferably to oxidize as much of overfill 30 as possible without substantially oxidizing conductor 28. Optimally, overfill 30 would be oxidized at or almost at line 26. This would make it easier to remove oxidized overfill 30 by either CMP, wet etching, or dry etching. Preferably, the oxidation would occur by subjecting the film to an oxygen containing ambient (such as O₂ or O₃) at or above room temperature (preferably above room temperature - more preferably around 125°C). This can be accomplished by placing the semiconductor wafer in a diffusion furnace, a rapid thermal anneal furnace, or an oven and heating it in an oxygen containing ambient. The subsequent removal of the oxided film (preferably a CU₂O, Cu), or CuO₄ film) is, preferably, accomplished either by subjecting the wafer to a wet etchant (preferably a dilute HCI solution, or a dilute H₂SO₄ solution), a dry etch method, and/or CMP. The result of this step is depicted in FIGURE 1c. Liner 31 may or may not be removed. Optionally, this removal step is followed by corrosion inhibiting step which is comprised of dipping the wafers in benzotriazole (BTA), tolytriazole (TTA), BTA and KI solution, or TTA and KI solution. Preferably, this step will form a thin film on the copper containing layer which will later be removed. In an alternate embodiment of the instant invention, a portion of overfill portion 30 of the copper-containing material may be oxided and then removed either by a wet etch, a dry etch and/or CMP. Next, this step is repeated several times until the entire portion of overfill 30 is removed (up to line 26).

In another embodiment, a mask 32, which oxygen will not diffuse through, is formed over overfill material 30. Preferably, mask 32 will prevent the oxygen from rapidly diffusing through copper-containing overfill 30 and oxidizing conductive line 28 and via/contact/interconnect 24. If the oxygen diffuses laterally in overfill material 30 then the portion under mask 32 will be oxidized to some extent. The width of mask 32 can be altered depending on the amount of lateral and vertical diffusion of the oxygen through overfill region 30.

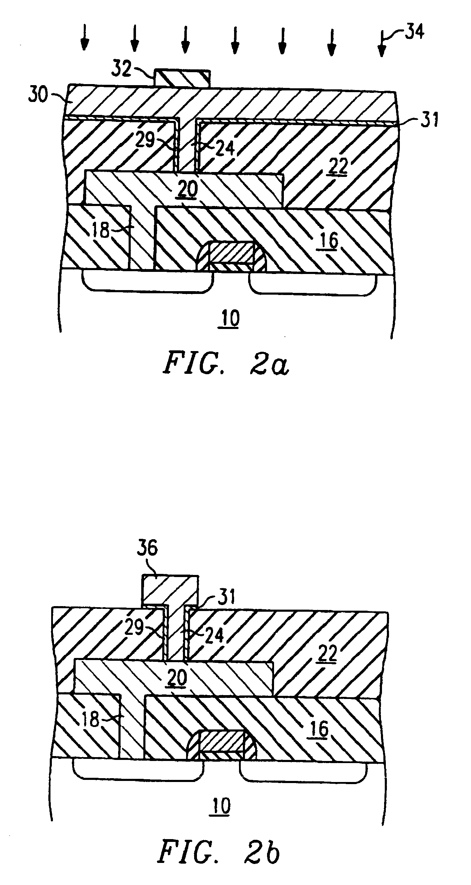

The device of FIGUREs 2a and 2b is approximately the same as the device fabricated in FIGUREs la-lc. However, the device of FIGUREs 2a and 2b does not utilize the damascene process. Therefore, another embodiment of the instant invention is utilized so as to remove unwanted portions of overfill 30. In this embodiment of the instant invention, at least a portion of overfill 30 is subjected to an oxidizing ambient (preferably an O₂ or O₃ ambient in a diffusion furnace, a rapid thermal anneal chamber, or an oven) at an elevated temperature (preferably above room temperature - preferably around 120°C). A mask 32 (preferably comprised of a material that will not oxidize or allow oxygen to pass through it - preferably a nitride film) may be used to prevent or reduce oxidation of metal region 30 under mask 32 and the remaining metal conductor. Mask 32 may be necessary if the oxygen rapidly diffuses vertically through copper-containing material 30. If it does diffuse rapidly with little or no lateral diffusion, then mask 32 will need to be at least as wide as conductive line 36. If the oxygen diffuses laterally, then mask 32 may need to be wider than conductive line 36 because the oxygen will diffuse (to some extent) under mask 32. If the oxygen does not diffuse rapidly in the vertical direction, then mask 32 may not be needed. If mask 32 is used, it will be removed as overfill material is removed. Otherwise, the oxidation step is continued until most of overfill portion 30 is oxided, but they must not be continued too long so that there is not any appreciable oxidation of metal structure 24 or of the remaining metal structure 36.

Next, the oxidized portions of copper-containing material 30 is removed either by wet etching, dry etching, and/or CMP. The goal is to be able to easily remove the unwanted portions of copper-containing layer 30 without substantially degrading the electrical or reliability properties of conductors 24 and 36.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

## Claims

1. A method of forming a conductive structure comprised of copper over a semiconductor substrate, said method comprising the steps of:
depositing a copper-containing material over said substrate;
selectively oxidizing portions of said copper-containing material;
and removing said oxidized portions of said copper-containing material.

2. A method of forming an interconnect/contact/via over a semiconductor substrate, said method comprising the steps of:
providing a dielectric layer over said substrate, said dielectric layer having an opening extending from an upper surface to a lower surface thereof;
depositing a copper-containing material so as to substantially fill said opening in said dielectric layer, said copper-containing material also being disposed on said upper surface of said dielectric layer;
oxidizing portions of said copper-containing material; and
removing said oxidized portions of said copper-containing material.

3. The method of Claim 2, further comprising:
oxidizing substantially all of the copper-containing material overlying said dielectric layer while said copper-containing material which substantially fills said opening in said dielectric layer remains substantially unoxidized.

4. The method of Claim 2 or Claim 3, further comprising: forming a mask which does not readily oxidize and which does not readily allow oxygen to diffuse through it over said portion of said copper-containing material which fills the opening in said dielectric layer.

5. The method of any of Claims 1 to 4, wherein said copper-containing material is comprised of substantially pure copper.

6. The method of any of Claims 1 to 4, wherein said copper-containing material is comprised of aluminum doped with copper.

7. The method of Claim 6, wherein said aluminum doped with copper contains at least 0.5% by weight of copper.

8. The method of any of Claims 1 to 7, wherein a mask is formed over a portion of said copper-containing material so as to retard oxidation of said copper-containing material under said mask.

9. The method of Claims 1 to 8, wherein said step of removing said oxidized portions of said copper containing material is performed by chemical mechanical polishing of the oxidized portions.

10. The method of any of Claims 1 to 8, wherein said step of removing said oxidized portions of said copper containing material is performed by etching the oxidized portions.

11. The method of any of Claims 5 to 10, wherein said copper-containing material is comprised of aluminum doped with at least 0.5% copper by weight.

12. The method of any of Claims 1 to 11, wherein said step of removing said oxidized portions of said copper-containing material is comprised of performing chemical mechanical polishing.

13. The method of any of Claims 1 to 12, wherein said step of removing said oxidized portions of said copper-containing material is comprised of performing a blanket etch process.

14. A semiconductor device formed in a fabrication process comprising a method according to any preceding claim.
